Europäisches Patentamt

European Patent Office

Office européen des brevets

(19)

(11) **EP 1 569 005 A2**

(12) **EUROPEAN PATENT APPLICATION**

(43) Date of publication:
**31.08.2005 Bulletin 2005/35**

(51) Int Cl.7: **G01R 35/00**

(21) Application number: **05250831.4**

(22) Date of filing: **14.02.2005**

| | |
|---|---|
| (84) Designated Contracting States:<br>**AT BE BG CH CY CZ DE DK EE ES FI FR GB GR HU IE IS IT LI LT LU MC NL PL PT RO SE SI SK TR**<br>Designated Extension States:<br>**AL BA HR LV MK YU**<br><br>(30) Priority: **25.02.2004 US 786446**<br>**27.01.2005 US 45413**<br><br>(71) Applicant: **TEKTRONIX, INC.**<br>**Beaverton, OR 97077-0001 (US)**<br><br>(72) Inventors:<br>• **Pickerd, John J.**<br>**Hillsboro, Oregon 97123 (US)** | • **Tan, Kan**<br>**Beaverton, Oregon 97007 (US)**<br>• **Hagerup, William A.**<br>**Portland, Oregon 97229 (US)**<br>• **Anderson, Rolf P.**<br>**Portland, Oregon 97223 (US)**<br>• **McMasters, Sharon M.**<br>**Sherwood, Oregon 97140 (US)**<br><br>(74) Representative: **Burke, Steven David et al**<br>**R.G.C. Jenkins & Co.**<br>**26 Caxton Street**<br>**London SW1H 0RJ (GB)** |

(54) **Calibration method and apparatus**

(57)    A method and apparatus adapted to calibrate a test probe and oscilloscope system such that loading effects of the probe are substantially removed from the measurement.

FIG.1

Printed by Jouve, 75001 PARIS (FR)

**Description**

FIELD OF THE INVENTION

The invention relates generally to signal acquisition systems and, more particularly, to a system, apparatus and method for reducing measurement errors due to, for example, probe tip loading of a device under test.

BACKGROUND OF THE INVENTION

Typical probes used for signal acquisition and analysis devices such as digital storage oscilloscopes (DSOs) and the like have an impedance associated with them which varies with frequency. For example, a typical probe may have an impedance of 100K to 200K Ohms at DC, which impedance drops towards 200 ohms at 1.5 GHz. Higher bandwidth probes drop to even lower impedance values. This drop in impedance as frequency increases, coupled with the fact that many circuits being probed have a relatively low output impedance in the range of 25-150 ohms, results in a significant loading of the circuit under test by the probe. As such, an acquired waveform received via a probe loading such a circuit may not accurately represent the voltage of the circuit prior to the introduction of the probe.

SUMMARY OF INVENTION

These and other deficiencies of the prior art are addressed by the present invention of a system, apparatus and method for reducing measurement errors due to, for example, probe tip loading of a device under test. Briefly, the invention provides a method to calibrate a probe and oscilloscope system so that loading and through effects of the probe and oscilloscope are substantially removed from the measurement. As a result, the user will see a time domain display that represents the signal in a circuit under test as it would appear before the probe is attached to the circuit.

Specifically, an apparatus according to one embodiment of the invention is adapted for use with a test probe, the test probe having associated with it an impedance, the apparatus comprising a memory, for storing transfer parameters associated with the probe impedance; and a controllable impedance device, for adapting an effective input impedance of the test probe in response to the stored transfer parameters.

A method according to one embodiment of the invention comprises acquiring a plurality of samples from a device under test via a signal path including a plurality of selectable impedance loads; adapting the selectable impedance loads to characterize the impedance of the DUT within at least one of a spectral and amplitude domain; computing an equalization filter adapted to compensate for loading of the DUT caused by measurement of the DUT; acquiring samples from the DUT via a signal path not including the selectable impedance loads; and processing the acquired samples using the equalization filter to effect thereby a reduction in signal error attributable to the measurement loading of said DUT.

BRIEF DESCRIPTION OF THE DRAWINGS

The teachings of the present invention can be readily understood by considering the following detailed description in conjunction with the accompanying drawings, in which:

FIG. 1 depicts a high level block diagram of a testing system including a device under test arranged in accordance with an embodiment of the present invention;
FIG. 2 depicts a high level block diagram of a signal analysis system;
FIG. 3 depicts a high level block diagram of a probe normalization fixture suitable for use in the system of FIG. 1;
FIG. 4 depicts an exemplary two-port model of a probe normalization test channel;
FIG. 5 depicts a flow diagram of a method according to an embodiment of the invention;
FIG. 6 illustrates one embodiment of the present invention; and
FIG. 7 depicts a user interface screen suitable for use in an embodiment of the present invention.

To facilitate understanding, identical reference numerals have been used, where possible, to designate identical elements that are common to the figures.

DETAILED DESCRIPTION OF THE INVENTION

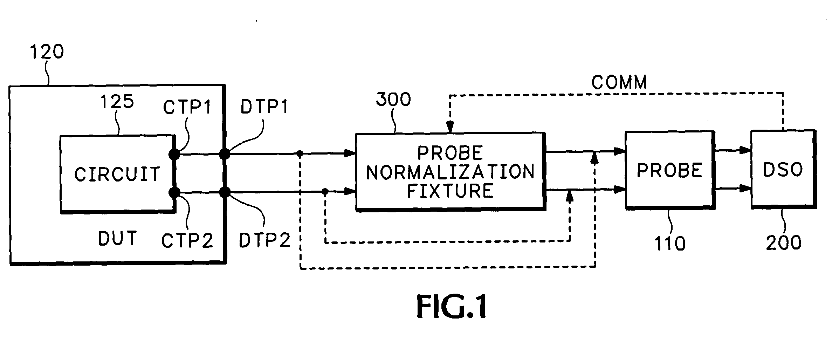

FIG. 1 depicts a high level block diagram of a testing system including a device under test arranged in accordance with an embodiment of the present invention. Specifically, a probe 110 is operably coupled to a signal analysis device such as a DSO 200 to provide thereto a signal under test (SUT) received from a device under test (DUT) 120.

Interposed between the DUT 120 and the probe 110 is a probe normalization fixture 300.

In a calibrate mode of operation, the signal path between the DUT 120 and probe 110 passes through the probe normalization fixture 300. In a non-calibration mode of operation, a signal path between the DUT 120 and probe 110 is direct and excludes the probe normalization fixture 300. The calibration mode signal path is indicated by an unbroken line, while the non-calibration mode signal path is indicated by a dotted line. It will be noted that the probe paths depicted in FIG. 1 comprise two probe paths such as used within the context of a differential probe. In alternate embodiments, a single-ended or non-differential probe is used in which a first path passes a signal under test while a second path is operatively coupled to a common or ground point. Generally speaking, the normalization fixture is adapted to enable characterization of the device under test such that an equalization filter may be computed. Upon removal of the normalization fixture from the signal path between the DUT 120 and probe 110, the equalization filter is used to process the acquired samples from the DUT such that signal degradation or artifacts imparted to the SUT provided by the DUT are compensated for within the system, effectively de-embedding the loading of the DUT by the test and measurement system.

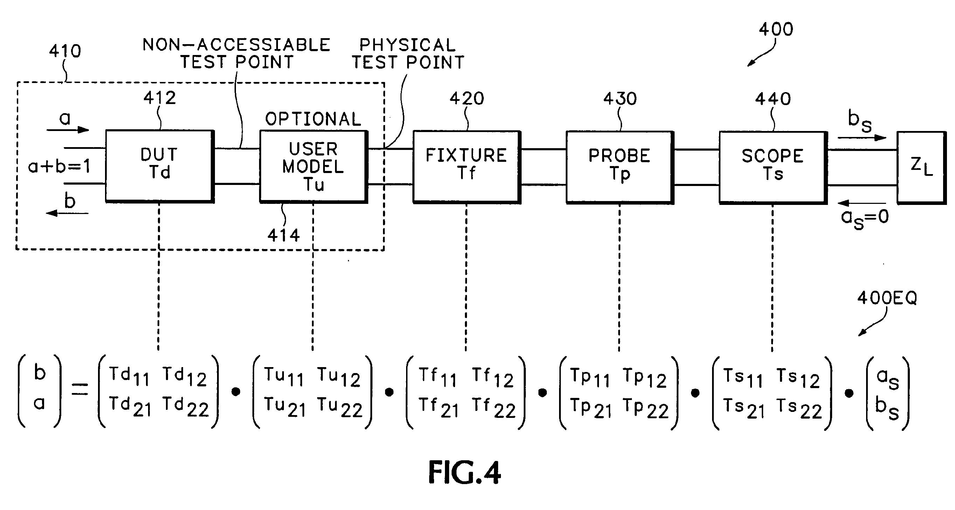

The (illustratively two) probe paths are coupled to the DUT 120 at a first device test point DTP1 and a second device test point DTP2. Optionally, internal to the DUT 120 is a circuit 125. The circuit 125 includes a first circuit test point CTP1 and a second circuit test point CTP2, where CTP1 is coupled to DTP1 and CTP2 is coupled to DTP2. For example, the DUT 120 may comprise an integrated circuit (IC) having a plurality of pins including pins associated with the test points DTP1 and DTP2, while a die within the IC includes the circuit test points CTP1 and CTP2. The difference in these tests points and the characterization of the operating parameters associated with these test points will be discussed in more detail below with respect to FIG. 4.

The invention operates to calibrate the probe 110 and, optionally, DSO input channel to remove (i.e., de-embed) their respective signal degrading effects from the measurement of the DUT (or circuit). This de-embedding process is conducted by characterizing the probe and other elements using a two-port S parameter or T parameter representation, which representation may be used to adjust impedance normalization parameters within the probe normalization fixture 300 and/or filter parameters used to process an acquired sample stream within the DSO 200.

Optionally, a user may insert a mathematical model such as a two-port S parameter or T parameter representation into the signal measurement path to compensate for signal degradations or characteristics between the scope probe tip and the specific measurement point of a device under test. In this manner, an integrated circuit (IC) may be probed at its respective test point to provide, with mathematical compensation of the signal path between the test points (e.g., DTP1, DPT2) and the die interface (e.g., CTP1, CTP2), a voltage or signal for analysis that accurately represents the signal at the die itself. Generally speaking, the invention may utilize transfer parameters received from, e.g., the user that characterize a circuit between the test probe and the DUT such that the calculations of an equalization filter and the like are further adapted to compensate for loading of the DUT caused by the circuit between the probe and said DUT. Such insertion of additional transfer parameters is also useful in determining the effect of different intermediate circuitry (i.e., between a DUT or DUT portion and test probe) such as different die layout, packaging, DUT output circuitry and the like.

In one embodiment, the invention comprises a probe tip fixture that is inserted between a test probe and a device under test (DUT) and used during a one button press calibration procedure. This calibration procedure uses no external voltage sources, only the signal under test provided by the device under test. The probe test fixture contains multiple loads (resistive and/or reactive impedances) that are selected based on the probe and in response to the device under test or signal produced by the device under test. The multiple loads comprise series, parallel and/or series/parallel combinations of resistive, capacitive and/or inductive elements. The multiple loads may be passive or active and may be selected using relays, solid state switching devices, or other selecting means. The probe tip fixture may comprise a stand-alone unit adapted to receive the probe or may be incorporated into the probe itself.

In one embodiment, the multiple loads are arranged as a load or impedance matrix. In various embodiments, the invention provides a new method and associated probe normalization fixture that allows the effects of probing to be de-embedded from the measurement of a device under test.

The invention utilizes a two-port matrix of S parameters or T parameters to model each element associated with the measurement signal path. Optionally, some elements are not modeled. The T parameters are used so that a two-port matrix for each of the elements of the system model may be computed in a straight forward manner by multiplying them in the order they occur in the signal path. T parameters are transfer parameters and are derived from S parameters.

T parameters for the normalization fixture and/or probe may be stored in the fixture itself, the probe or the DSO. In one embodiment, T parameters for the probe are stored in the probe while T parameters for the fixture are stored in the fixture. The scope channel T parameters are optionally stored in the DSO 200.

The signal provided by the DUT is used as the signal source for a calibration procedure. The scope collects measurements with each of at least some of the loads in the fixture and then computes the T parameters for the DUT. Once this is known, the fixture is removed and the probe is connected to the calibrated test point in the DUT. A correction filter based on the calibration is then applied to the acquired data such that the effects of probe loading as a function of frequency are removed or offset. The entire calibration process is automated and activated from, for example, a single menu button in the oscilloscope. It should be noted that the fixture may be left in place after the calibration process to improve accuracy by avoiding physical movement of the probing fixture (since slight changes in position can affect the calibration).

The relationship between S and T parameters will now be briefly discussed. It should be noted that while T parameters are primarily described within the context of the invention, the use of S parameters instead of T parameters is also contemplated by the inventors. Thus, S parameters may be substituted wherever the storage and/or use of T parameters is discussed herein. T parameters may be computed from the S parameters at the time the algorithms are processed. The relationship between T and S parameters is given by equations 1 and 2 below:

$$\begin{pmatrix} T_{11} & T_{12} \\ T_{21} & T_{22} \end{pmatrix} = \begin{pmatrix} -\dfrac{S_{11} \, S_{22} - S_{12} \, S_{21}}{S_{21}} & \dfrac{S_{11}}{S_{12}} \\ -\dfrac{S_{22}}{S_{21}} & \dfrac{1}{S_{21}} \end{pmatrix} \qquad \text{(EQ 1)}$$

$$\begin{pmatrix} S_{11} & S_{12} \\ S_{21} & S_{22} \end{pmatrix} = \begin{pmatrix} \dfrac{T_{12}}{T_{22}} & \dfrac{T_{11} \cdot T_{22} - T_{12} \cdot T_{21}}{T_{22}} \\ \dfrac{1}{T_{22}} & \dfrac{-T_{21}}{T_{22}} \end{pmatrix} \qquad \text{(EQ 2)}$$

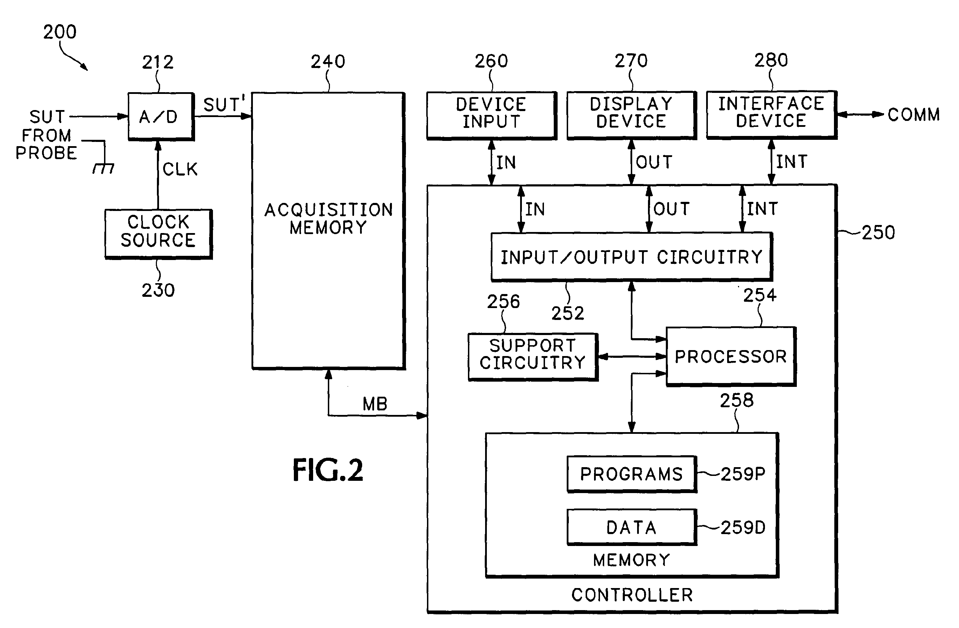

FIG. 2 depicts a high level block diagram of a signal analysis device such as a digital storage oscilloscope (DSO) suitable for use with the present invention. Specifically, the system (signal analysis device) 200 of FIG. 1 comprises an analog to digital (A/D) converter 212, a clock source 230, an acquisition memory 240, a controller 250, an input device 260, a display device 270 and an interface device 280.

The A/D converter 212 receives and digitizes an SUT in response to a clock signal CLK produced by the clock source 230. The clock signal CLK is preferably a clock signal adapted to cause the A/D converter 212 to operate at a maximum sampling rate, though other sampling rates may be selected. The clock source 230 is optionally responsive to a clock control signal CC (not shown) produced by the controller 250 to change frequency and/or pulse width parameters associated with the clock signal CLK. It is noted that the A/D converter 212 receives the SUT via a probe (not shown), which probe may comprise a differential probe or a single ended (i.e., non-differential) probe.

A digitized output signal SUT' produced by the A/D converter 212 is stored in the acquisition memory 240. The acquisition memory 240 cooperates with the controller 250 to store the data samples provided by the A/D converter 212 in a controlled manner such that the samples from the A/D converter 212 may be provided to the controller 250 for further processing and/or analysis.

The controller 250 is used to manage the various operations of the system 200. The controller 250 performs various processing and analysis operations on the data samples stored within the acquisition memory 240. The controller 250 receives user commands via an input device 260, illustratively a keypad or pointing device. The controller 250 provides image-related data to a display device 270, illustratively a cathode ray tube (CRT), liquid crystal display (LCD) or other display device. The controller 250 optionally communicates with a communications link COMM, such as a general purpose interface bus (GPIB), Internet protocol (IP), Ethernet or other communications link via the interface device 280. It is noted that the interface device 280 is selected according to the particular communications network used. An embodiment of the controller 250 will be described in more detail below.

The system 200 of FIG. 2 is depicted as receiving only one SUT. However, it will be appreciated by those skilled in the art that many SUTs may be received and processed by the system 200. Each SUT is preferably processed using a respective A/D converter 212, which respective A/D converter may be clocked using the clock signal CLK provided by a common or respective clock source 230 or some other clock source. Each of the additional digitized SUTs is coupled to the acquisition memory 240 or additional acquisition memory (not shown). Any additional acquisition memory communicates with the controller 250, either directly or indirectly through an additional processing element.

The controller 250 comprises a processor 254 as well as memory 258 for storing various programs 259P (e.g., calibration routines) and data 259D (e.g., T and/or S parameters associated with one or more components within the testing system). The processor 254 cooperates with conventional support circuitry 256 such as power supplies, clock circuits, cache memory and the like, as well as circuits that assist in executing the software routines stored in the memory 258. As such, it is contemplated that some of the process steps discussed herein as software processes may be implemented within hardware, for example as circuitry that cooperates with the processor 254 to perform various steps. The controller 250 also contains input/output (I/O) circuitry 252 that forms an interface between the various functional elements communicating with the controller 250. For example, the controller 250 communicates with the input device 260 via a signal path IN, a display device 270 via a signal path OUT, the interface device 280 via a signal path INT and the acquisition memory 240 via signal path MB. The controller 250 may also communicate with additional functional elements (not shown), such as those described herein as relating to additional channels, SUT processing circuitry, switches, decimators and the like. It is noted that the memory 258 of the controller 250 may be included within the acquisition memory 240, that the acquisition memory 240 may be included within the memory 258 of the controller 250, or that a shared memory arrangement may be provided.

Although the controller 250 is depicted as a general purpose computer that is programmed to perform various control functions in accordance with the present invention, the invention can be implemented in hardware as, for example, an application specific integrated circuit (ASIC). As such, the process steps described herein are intended to be broadly interpreted as being equivalently performed by software, hardware or a combination thereof.

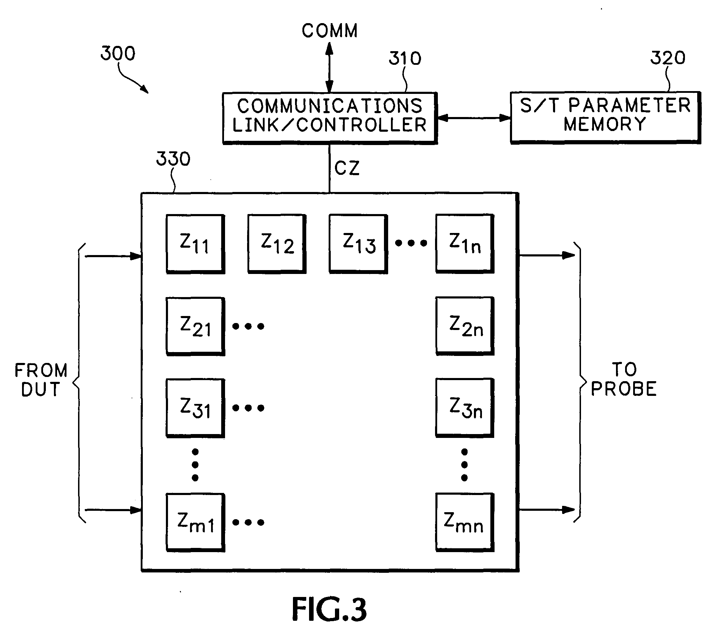

FIG. 3 depicts a high level block diagram of a probe normalization fixture suitable for use in the system of FIG. 1. Specifically, the probe normalization fixture 300 of FIG. 3 comprises a communication link/controller 310, an S or T parameter memory 320 and a selectable impedance matrix 330. The S/T parameter memory 320 is used to store S or T parameters associated with the probe 110 and, optionally, any of the DUT 120, circuit 125, DSO 200 or user supplied parameters. The parameters stored in the memory 320 are provided via, illustratively, the communication link/control circuit 310. The communication link/control circuit 310 is operatively coupled to a signal analysis device (e.g., a DSO), a computer (not shown) or other test system controller via a communication link COMM, illustratively an Ethernet, Universal Serial Bus (USB) or other communication link. The communication link/control circuit 310 also controls the selectable impedance matrix 330 via a control signal CZ.

The selectable impedance matrix 330 comprises a plurality of impedance elements Z arranged in matrix form. Specifically, a first impedance element in a first row is denoted as $Z_{11}$, while the last impedance element in the first row is denoted as $Z_{1n}$. Similarly, the last impedance element in a first column is denoted as $Z_{m1}$, while the last impedance in the nth column is denoted as $Z_{mn}$. While depicted as an mxn grid or matrix of selectable impedance elements, it will be noted that a more simplified array of impedance elements may be provided. It is also noted that each of the impedance elements may comprise a resistive element, a capacitive element, an inductive element and any combination of active or passive impedance elements. The impedance matrix 330 may provide serial, parallel, serial and parallel or other combinations of passive or active impedances to achieve the purpose of impedance normalization between the DUT (or circuit) and probe 110.

Generally speaking, the purpose of the impedance element matrix 330 is to adapt the input impedance of the probe 110 to the output impedance of the DUT 120 (or circuit 125) such that undue loading of the measured signal parameters is avoided or at least reduced, while there is enough signal passed into probe. At the same time various load ranges must be provided so that adequate DUT loading occurs to provide good signal to noise ratio for the calibration procedure. The impedance matrix may be modified to provide additional normalization. That is, rather than normalizing just the probe 110, the probe normalization fixture 300 may also be used to normalize the probe 110 in combination with the input channel of the DSO 200 utilizing the probe 110. Various other permutations will be recognized by those skilled in the art and informed by the teachings of the present invention.

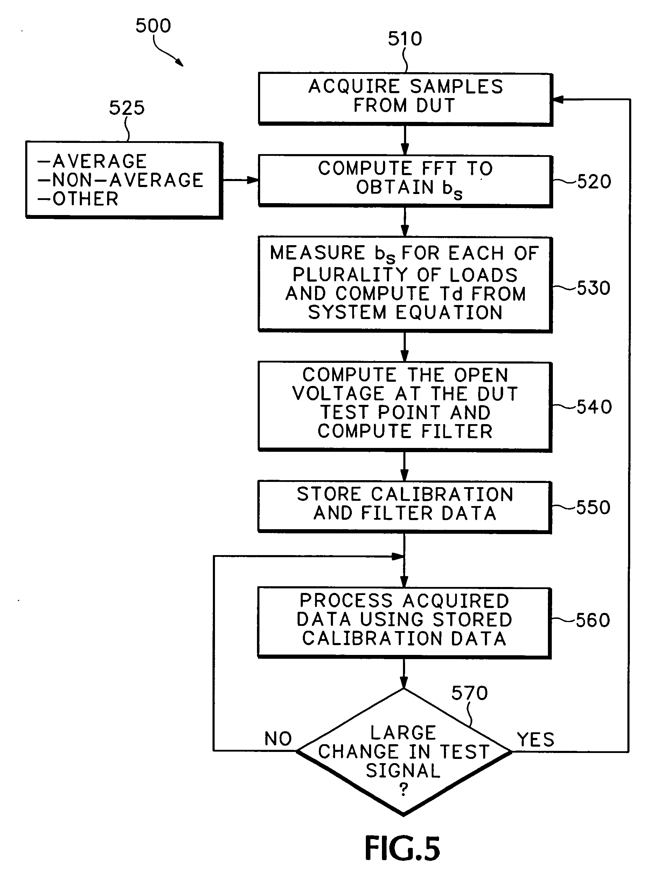

The probe normalization fixture may be a stand alone unit or incorporated within the probe 110. Generally speaking, the probe normalization fixture 300 comprises a set of input probe pins adapted for connection to the DUT and a set of output probe pins adapted for connection to the probe 110. In the case of the probe normalization fixture 300 being included within the probe 110, an electronic or mechanical selection means may be employed within the probe 110 to facilitate inclusion or exclusion of the probe normalization fixture function from the circuit path between the DUT and probe. An embodiment of the probe normalization fixture will be discussed in further detail below with respect to FIG. 5.

The S/T parameter memory 320 may comprise a non-volatile memory where S or T parameters for fixture loads are stored. These S or T parameters may be provided to an oscilloscope or computer via the communications link COMM such that additional processing may be performed within the signal analysis device. In one embodiment, the probe normalization fixture 300 has associated with it a plurality of probe tips adapted for use by, for example, different devices under test, different testing programs and the like (e.g., current probes, voltage probes, high-power probes and the like). Each of these probe tips may be characterized by respective T parameters or S parameters, which T parameters or S parameters may be stored in the memory 320 of the probe normalization fixture 300. In one embodiment, the communications link/controller 310 detects the type of probe tip attached and responsively adapts the T or S parameters within the memory 320. Thus, the T parameters or S parameters associated with specific probe tips of the normalization fixture 300 may be included within the set of equations describing the testing circuit. The T parameters or S parameters associated with one or more probe tips may be stored in memory within the probe, the probe tip, the oscilloscope or the fixture.

FIG. 4 depicts an exemplary two-port model and corresponding equations of a probe normalization test channel in which a plurality of elements within the test and measurement system are modeled as a series connection of T parameter 2-port networks. Specifically, the model 400 (and corresponding equations 400EQ) of FIG. 4 comprises a device under test 2-port network 410 (denoted as Td), a fixture 2-port network 420 (denoted as Tf), a probe 2-port network 430 (denoted as Tp)and a scope 2-port network 440 (denoted as Ts). The DUT 2-port network 410 is depicted as including a DUT network 412 (Td) and a user model 414 (denoted as Tu).

The user model 2-port network 414 (Tu) is optionally provided and gives a T parameter model for part of the hardware of a device under test. For example, the user model 414 may be used to represent the operating characteristics of a portion of a DUT between an accessible portion (i.e., where probes are operably coupled) to a desired test portion that is normally inaccessible within the DUT (i.e., a portion on the edge of or within a die). The user model accommodates this by letting the user load the s parameter model (or T parameter model) into, for example, the DSO, where it becomes part of the calibration process. For example, if the user knows the s parameters for a bond wire connection from an IC pin to a die chip, then the T parameter model of the connection may be included in the calculations as the Tu matrix. After system calibration, a probe of the IC pin will result in a waveform representing the die chip signal level.

In general, the invention operates to obtain a frequency domain result by using an FFT transform of the measured incident signal, $a_s$, for each calibration load in the fixture. After the final $v_{open}$ is computed the result is transformed back to the time domain by using an IFFT. In one embodiment, a filter is employed to implement the FFT and/or IFFT operations.

For illustrative purposes, several assumptions will be made. For initial derivations, the DUT 2-port model will be assumed to have input incidence signal of a and a reflected signal of b, where a and b are normalized such that a + b=1. The Td, user DUT, will have internal signal and this results in what will be called the normalized Td parameters. It is also assumed the measurement system will be modeled as a series of S parameter two port networks, which will be converted to T, transfer, parameters for ease of matrix solutions. These two port networks represent the user's circuit under test and are ordered (per FIG. 4 and equation 3) left to right as DUT, User DUT Model, Fixture, Probe, and Oscilloscope.

In order to simplify the measurement equations it will be assumed that the frequency response of the scope and it's input connector is flat enough. It will also be assumed that that the input voltage to port model Td is a + b, and that a + b is a constant voltage source internal to the Td circuit at it's input port. It will also be assumed that scope input channel and connector provides a relatively flat 50 ohm impedance match over the relevant bandwidth. However, other versions of the measurement may also take into account the parameters of the scope response. This does not preclude the possibility that the scope T parameters would also be included in the normalization. It is also possible that an assumption of $a_s$ equal zero at the two-port output of the s-parameter model for the scope might be made.

### _Equation 3_

$$\begin{pmatrix} b \\ a \end{pmatrix} = \begin{pmatrix} Td_{11} & Td_{12} \\ Td_{21} & Td_{22} \end{pmatrix} \cdot \begin{pmatrix} Tu_{11} & Tu_{12} \\ Tu_{21} & Tu_{22} \end{pmatrix} \cdot \begin{pmatrix} Tf_{11} & Tf_{12} \\ Tf_{21} & Tf_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} a_s \\ b_s \end{pmatrix}$$

Where: Td is the transfer parameters of the DUT;

Tu is a user model of part of circuit under test;
Tf is the transfer parameters of the probe test fixture;
Ts is the transfer parameters of the oscilloscope

Tp is the transfer parameters of the probe;

$b_s$ is the voltage measured at the DSO output; and

$a_s$ is the reflected voltage at the DSO output (assumed to be zero for this derivation, though other derivations and implementation may include it).

Considering the assumptions that a+b=1 and $a_s$=0, EQ 3 can be re-written as follows:

*Equation 3A*

$$(1 \quad 1)\begin{pmatrix} b \\ a \end{pmatrix} = (1 \quad 1)\begin{pmatrix} Td_{11} & Td_{12} \\ Td_{21} & Td_{22} \end{pmatrix} \cdot \begin{pmatrix} Tu_{11} & Tu_{12} \\ Tu_{21} & Tu_{22} \end{pmatrix} \cdot \begin{pmatrix} Tf_{11} & Tf_{12} \\ Tf_{21} & Tf_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_s \end{pmatrix}$$

such that:

*Equation 3B*

$$1 = a + b = (Td_1 \quad Td_2) \cdot \begin{pmatrix} Tu_{11} & Tu_{12} \\ Tu_{21} & Tu_{22} \end{pmatrix} \cdot \begin{pmatrix} Tf_{11} & Tf_{12} \\ Tf_{21} & Tf_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_s \end{pmatrix}$$

where:

$$Td_1 = Td_{11} + Td_{21}$$

$$Td_2 = Td_{12} + Td_{22} \tag{EQ 3C}$$

It should be noted that a different set of Tf for each of the loads switched onto the DUT. The values of Tf, and Tp are measured at time of manufacture and stored in the probe and fixture respectively. The values of Td are computed by making a measurement of $a_s$ with each of the loads of Tf and then solving the appropriate set of equations. The test setup requires that test fixture connect to DUT and that probe connects into test fixture.

FIG. 5 depicts a flow diagram of a method according to an embodiment of the invention. The method 500 of FIG. 5 is suitable for use in, for example, the system 100 of FIG. 1. The method utilizes the two port model discussed above and assumes that the test signal provided by the DUT is a relatively steady-state signal (i.e., relatively stable or repeating spectral and/or time domain energy distribution). The equations discussed herein with respect to FIG. 5 (and other figures) depict a plurality of two-port representations including device under test, user, normalization fixture, probe and/or scope T parameters. The invention may be practiced using only the device parameters Td, fixture parameters Tf and probe parameters Tp where method and apparatus according to the invention are adapted for compensating for the loading imparted to a device under test by a probe. The addition of the scope T parameters Ts and/or user parameters Tu may be employed in various embodiments. Thus, equations provided herein may be utilized without the user (Tu) and/or scope (Ts) parameters.

The method 500 is entered as step 510, where time domain samples are acquired from the DUT.

At step 520, a Fast Fourier Transform (FFT) is computed to obtain the obtain $b_s$. Referring to box 525, the computation may be performed using averaged or non-averaged data.

At step 530, $b_s$ is measured and Td is computed for each of a plurality of load selections (within the normalization fixture). Td is computed using (for the exemplary embodiment), the following equations:

*Equation 4*

$$1 = \begin{pmatrix} Td_1 & Td_2 \end{pmatrix} \cdot \begin{pmatrix} Tu_{11} & Tu_{12} \\ Tu_{21} & Tu_{22} \end{pmatrix} \cdot \begin{pmatrix} Tf1_{11} & Tf1_{12} \\ Tf1_{21} & Tf1_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_s \end{pmatrix}$$

*Equation 5*

$$1 = \begin{pmatrix} Td_1 & Td_2 \end{pmatrix} \cdot \begin{pmatrix} Tu_{11} & Tu_{12} \\ Tu_{21} & Tu_{22} \end{pmatrix} \cdot \begin{pmatrix} Tf2_{11} & Tf2_{12} \\ Tf2_{21} & Tf2_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_{2s} \end{pmatrix}$$

*Equation 6*

$$1 = \begin{pmatrix} Td_1 & Td_2 \end{pmatrix} \cdot \begin{pmatrix} Tu_{11} & Tu_{12} \\ Tu_{21} & Tu_{22} \end{pmatrix} \cdot \begin{pmatrix} Tf3_{11} & Tf3_{12} \\ Tf3_{21} & Tf3_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_{3s} \end{pmatrix}$$

To solve for the variables *Td1* and *Td2*, two equations obtained from measurements with two different loads are sufficient. However, the inventors note that multiple equations from multiple measurements using different loads can improve the accuracy of *Td1* and *Td2* values by, for example, simple averaging or minimum least square error methods.

At step 540, the open voltage at the DUT probe point is calculated by replacing the two-port network with a two-port representation of an open circuit, as follows:

$$1 = \begin{pmatrix} Td_1 & Td_2 \end{pmatrix} \cdot \begin{pmatrix} 1 & 0 \\ 0 & 1 \end{pmatrix} \cdot \begin{pmatrix} a_0 \\ b_0 \end{pmatrix} \tag{EQ 7}$$

The inventors note that the open circuit voltage $v_{open}$ is actually twice the value of $a_o$ since in the open circuit case $a_o = b_o$ and $v_{open} = a_o + b_o$, such that:

$$v_{open} = 2\, a_0 = \frac{2}{Td_1 + Td_2} \tag{EQ 8}$$

In one embodiment of the invention, at step 540 the equations are derived from the above measurements to realize a time domain filter response. The time domain response of the filter can be derived from its transfer function. The filter transfer function is as follows:

$$H = \frac{v_{open}}{b_{is}} \tag{EQ 9}$$

such that:

$$\hat{v}_{open} = H \cdot \hat{b}_s \tag{EQ 10}$$

where $b_{is}$ is the scope measurement $i$-th load during calibration procedure,

and $b_s$ is the scope measurement with the same $i$-th load during testing procedure.

The above response is then convolved with each new acquisition with the probe at a test point to provide thereby a de-embedded response at the DUT test point. Thus, the T parameters for the DUT (and, optionally, corresponding parameters for the normalization fixture, probe and/or scope) are determined such that an equalization filter based upon the various parameters with the normalization fixture removed may be determined. This filter is applied after the normalization fixture is removed from the circuit and the scope probe is connected to the same point in the DUT where the fixture calibration process was performed. In this manner, the normalization fixture is used to characterize the loading of the system upon the device under test and such that an equalization filter may be provided wherein such device loading is compensated for. Alternatively, the fixture may be left in place without perturbing the physical positions for better de-embed accuracy. The filter is then applied to the acquired signal.

At step 550, the calibration data and, optionally, filter data is stored in, for example, the data portion 259D of the memory 258. It is noted that in the above solution (EQ 8), the term $a_o$ represents the voltage in the DUT probe point with substantially all effects of probing de-embedded. This is the desired result of the calibration process. An inverse FFT of $v_{open}$ yields the time domain version of this signal. As a practical matter, it is noted that the physical movement of a probe (especially a non-differential probe) will slightly perturb the characteristics and, therefor, a new calibration might be desired. Alternatively, the fixture may be left in place without perturbing the physical positions for better de-embed accuracy.

At steps 560 and 570 the method operates to repeatedly process acquired data using the stored calibration data to provide de-embedded data for generating waveforms, providing test data to remote devices and the like. Upon detecting (at step 570) a relatively large change in the test signal, the method proceeds to step 510. For example, in one embodiment of the invention, during calibration the changes in measured voltages as a function of frequency for various loads connected is noted by the controlling device (e.g., a DSO). The controlling device then chooses only those loads that give minimal change in DUT voltage while still providing enough change to have a reasonable signal to noise ratio for the de-embed computations.

In one embodiment of the invention, once calibration has been performed and the DUT signal is being observed with de-embedding, the user is alerted if a major difference in the signal occurs in terms of signal level or waveshape. In an alternate embodiment, another calibration is performed for this case so that the user can make determinations of circuit linearity based on signal level. For example if the DUT signal was calibrated with one level and then changed to another amplitude level then the user measures the new level with the current calibration. Then the user optionally performs a new calibration and measure this signal again. If the measured results are different between the two calibrations then that would be an indication of non-linear DUT behavior at different signal levels.

In still another embodiment, where the user knows the S- or T-parameters of a particular test point, those test parameters are loaded into the testing or controlling device via, for example, the above-described menu structure. In this embodiment, there is no need to connect the de-embed fixture and the probe is directly connected to the test point.

New data $b_s$ is acquired and now the values of $a_{in}$ and $b_{in}$ are computed as shown in the following equation:

$$\begin{pmatrix} b_{in} \\ a_{in} \end{pmatrix} = \begin{pmatrix} Td_{11} & Td_{12} \\ Td_{21} & Td_{22} \end{pmatrix} \cdot \begin{pmatrix} Tu_{11} & Tu_{12} \\ Tu_{21} & Tu_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_s \end{pmatrix} \quad \text{(EQ 11)}$$

Once $a_{in}$ and $b_{in}$ are known, then the probe two-port matrix can be replaced with an open circuit two-port representation, identity matrix, and the DUT test point voltage can be computed as $2a_{open}$, as follows:

$$\begin{pmatrix} b_{in} \\ a_{in} \end{pmatrix} = \begin{pmatrix} Td_{11} & Td_{12} \\ Td_{21} & Td_{22} \end{pmatrix} \cdot \begin{pmatrix} 1 & 0 \\ 0 & 1 \end{pmatrix} \cdot \begin{pmatrix} a_{open} \\ b_{open} \end{pmatrix} \quad \text{(EQ 12)}$$

As previously noted, an IFFT of $a_{open}$ is computed to obtain the time domain version of the signal under test.

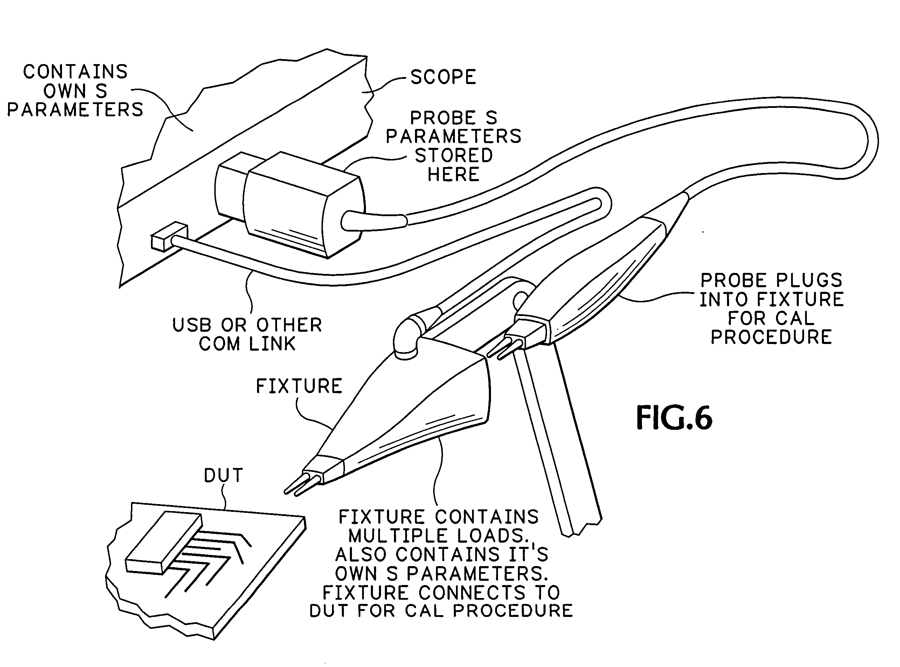

FIG. 6 illustrates one embodiment of the present invention. Specifically, FIG. 6 graphically illustrates an embodiment of the invention wherein a scope (optionally storing S parameters and/or T parameters) is operatively coupled to a probe. The probe optionally stores S parameters and/or T parameters in, for example, a non-volatile memory within the probe connector housing. A normalization fixture containing multiple loads and/or an impedance matrix such as described above with respect to FIG. 3 is adapted to receive the probe at an input. The normalization fixture is also adapted to receive a communication link from the scope. The normalization fixture optionally stores its own S parameters and/or T parameters. The normalization fixture includes a probe tip adapted to electrically probe a device under test, such as described above with respect to the various figures. It should be noted that the separate communication link cable between the normalization fixture and the scope shown in FIG. 6 may be integrated with the probe cable. It should also be noted that the function of the normalization fixture may be included within the probe.

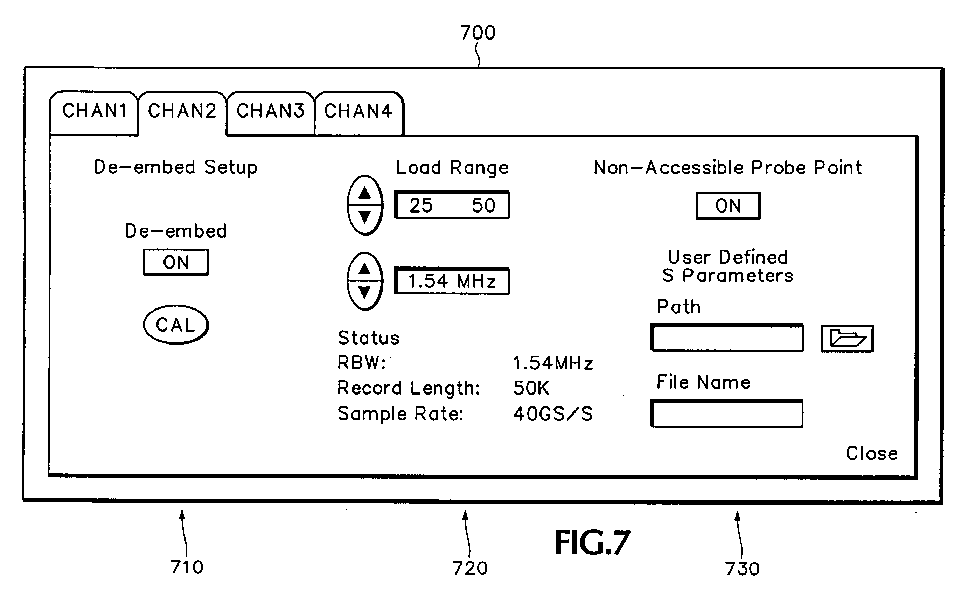

FIG. 7 depicts a user interface screen suitable for use in an embodiment of the present invention. Specifically, FIG. 7 depicts a de-embed set-up menu 700 comprising de-embed selector commands 710, load range commands 720 and non-accessible probe point commands 730. The de-embed set-up menu 700 may be accessed directly or via other menus (not shown) within the menu structure or hierarchy of a digital storage oscilloscope, computer or other test and measurement device.

Referring to the de-embed set-up commands 710, a first button denoted as "ON" is used to enable or disable the de-embed function, while a second button denoted as "CAL" is used to enable calibration of a test system according to the system, method and apparatus discussed above. That is, assuming the de-embed function is enabled, a calibration function is utilized wherein a probe is connected to a normalization fixture, the normalization fixture is connected to a device under test, the calibration button is pressed, and the resulting waveforms are viewed after processing according to, for example, the method described above with respect to FIG. 5.

The load range functions 720 allow user selection of a range of DUT log impedance (illustratively 25-50 ohms) via a first dialog box and a resolution bandwidth (RBW, illustratively 1.54 MHz) via a second dialog box. A status box provides an indication to a user of, illustratively, a bandwidth range, a record length (illustratively 50 KB) and a sample rate (illustratively 40 GS/s). Other information may be included within the status indication box.

Referring to the non-accessible probe point command 730, a first button denoted as "ON" enables the use of user defined S or T parameters within the context of the present invention. That is, where a user wishes to incorporate the S or T parameters associated with a two-port network mathematically inserted between the DUT and normalization fixture two-port networks (or other location), those S or T parameters are provided by the user as a file. Thus, the non-accessible probe point commands include a path dialog box enabling the user to identify where within the mass storage structure of the DSO the files are located, and a file name dialog box indicating the name of the user supplied S or T parameter file.

In one embodiment of the invention, an option to "View DUT test point with probe load" is provided via, for example, the user interface. In this embodiment, once the initial measurements have been made and the appropriate characterizing equations determined, a computation is made to determine what the DUT test voltage would look like with the probe "load" ($S_{11}$) connected. This operation is valid where it is assumed that the $S_{21}$ parameter approaches (ideally) negative infinity. In this manner, a user may examine the signal at the DUT probe point with and without the signal corrections (i.e., what is "really" there without the probe and what is "really" there with the probe). This embodiment finds utility in environments where, for example, probe loading and other effects are assumed to present (e.g., a previously calibrated automatic test system/suite).

Thus, the subject invention may selectively provide one or more of a compensated result, a partially compensated result or an uncompensated result. A compensated result comprises a measurement of the DUT test point in which probe loading, user provide characteristics and other characteristics are addressed in the manner described herein. A partially compensated result comprises a measurement of the DUT test point in which only some of the probe loading, user provide characteristics and other characteristics are addressed in the manner described herein. An uncompensated result comprises a measurement of the DUT test point in which the various loading parameters are not compensated for. The selection of compensated, partially compensated and uncompensated modes of operation may be made via, for example, the user interface screens discussed herein with respect to FIG. 7 as modified to provide appropriate mode selection buttons, dialog boxes or other objects.

Various embodiments of the invention offer a number of advantages, such as: (1) Providing a more accurate view of users' waveform with probing affects removed; (2) the calibration process is one button press while fixture is attached to probe end; (3) the calibration process requires no external signal sources; the oscilloscope may view non-accessible probing points in user circuit by allowing them to load s parameter model for part of their circuit; (5) the calibration or normalization fixture can be removed and calibration information is stored in the oscilloscope such that the same test point on multiple user boards can be probed and compared; (6) the probe scope channel bandwidth can be increased by this calibration process; and (7) the risetime of the probe and scope channel can be decreased.

To optimally de-embed the probe effects requires knowledge of the s parameters of the DUT. This invention, unlike existing probe calibration methods, provides method and apparatus for, e.g., an oscolloscope to measure the DUT S parameters (or T parameters) and provide thereby a true de-embed capability.

While the foregoing is directed to the preferred embodiment of the present invention, other and further embodiments of the invention may be devised without departing from the basic scope thereof, and the scope thereof is determined by the claims that follow.

**Claims**

1. Apparatus adapted for use with a test probe, said test probe having associated with it an impedance, said apparatus comprising:

   a memory, for storing transfer parameters associated with said probe impedance; and
   a controllable impedance device, for adapting an effective input impedance of said test probe in response to said stored transfer parameters.

2. The apparatus of claim 1, further comprising:

   a controller, for adapting said stored transfer parameters in response to a control signal.

3. The apparatus of claim 1, further comprising:

   a display device, for displaying a waveform representing a signal received from said test probe and adapted according to said transfer parameters.

4. The apparatus of claim 1, wherein:

   said controllable impedance device comprises a selectable network of resistive and reactive components.

5. The apparatus of claim 1, wherein:

   said apparatus comprises a test fixture adapted to connect the signal from said DUT to a tip of said test probe.

6. The apparatus of claim 5, wherein:

   said test fixture connects with said DUT via a test fixture probe tip.

7. The apparatus of claim 6, wherein said test fixture probe tip comprises any one of a plurality of test fixture probe tips, each of said test fixture probe tips having associated with it a respective transfer parameter stored in said memory.

8. The apparatus of claim 7, wherein:

   in response to the connection of a test fixture probe tip to said test fixture, said transfer parameter associated with said connected test fixture probe tip is used to adapt said controllable impedance device.

9. The apparatus of claim 1, wherein:

   said apparatus is integrated into said test probe.

10. The apparatus of claim 1, further comprising:

    a communications processor, adapted for receiving transfer parameters from a communications medium.

11. The apparatus of claim 1, wherein:

    said transfer parameters comprise at least one of S parameters and T parameters

12. The apparatus of claim 1, wherein:

    said memory stores transfer parameters associated with at least one of said DUT and a signal acquisition device adapted for use with said test probe.

13. The apparatus claim 12, wherein:

said memory further stores additional transfer parameters, said additional transfer parameters adapted to characterize a circuit disposed between a test point accessible to said probe and a non-accessible test point.

**14.** The apparatus claim 12, wherein:

said memory further stores user provided transfer parameters, said additional transfer parameters adapted modify an impedance characterization of at least one of a probe, a device under test and circuitry disposed between said probe and said DUT.

**15.** The apparatus of claim 1, wherein:

said apparatus selectively adapts said effective input impedance of said test probe to provide thereby compensated result and a non-compensated result.

**16.** The apparatus of claim 15, wherein:

said compensated result may comprise a partially compensated result.

**17.** A method, comprising:

acquiring a plurality of samples from a device under test via a signal path including a plurality of selectable impedance loads;
adapting said selectable impedance loads to characterize the impedance of said DUT within at least one of a spectral and amplitude domain;
computing an equalization filter adapted to compensate for loading of said DUT caused by measurement of said DUT;
acquiring samples from said DUT via a signal path not including said selectable impedance loads; and
processing said acquired samples using said equalization filter to effect thereby a reduction in signal error attributable to said measurement loading of said DUT.

**18.** The method of claim 17, wherein said step of adapting said selectable impedance loads comprises computing, for each of a plurality of load selections, parameters associated with a two-port network representation of the following form:

$$1 = \begin{pmatrix} Td_1 & Td_2 \end{pmatrix} \cdot \begin{pmatrix} Tu_{11} & Tu_{12} \\ Tu_{21} & Tu_{22} \end{pmatrix} \cdot \begin{pmatrix} Tfi_{11} & Tfi_{12} \\ Tfi_{21} & Tfi_{22} \end{pmatrix} \cdot \begin{pmatrix} Tp_{11} & Tp_{12} \\ Tp_{21} & Tp_{22} \end{pmatrix} \cdot \begin{pmatrix} Ts_{11} & Ts_{12} \\ Ts_{21} & Ts_{22} \end{pmatrix} \cdot \begin{pmatrix} 0 \\ b_{is} \end{pmatrix}$$

**19.** The method of claim 18, further comprising:

computing an open circuit voltage ($v_{open}$) at the device under test probe point using an equation of the following form:

$$v_{open} = 2\, a_0 = \frac{2}{Td_1 + Td_2}$$

**20.** The method of claim 19, wherein the open circuit voltage $\hat{v}_{open}$ is realized using a filter having a transfer function of the following form:

$$H = \frac{v_{open}}{b_{is}}$$

such that:

$$\hat{v}_{open} = H \cdot \hat{b}_s$$

where $b_{is}$ is a measurement of an *i*-th load during a calibration procedure, and $\hat{b}_s$ is a measurement of the *i*-th load during a testing procedure.

**21.** The method of claim 18, further comprising:

computing an open circuit voltage ($v_{open}$) at the device under test probe point using at least one of an S parameter and a T parameter associated with the device under test.

**22.** The method of claim 18, further comprising:

receiving transfer parameters characterizing a circuit between said probe and said DUT;
said equalization filter further adapted to compensate for loading of said DUT caused by said circuit between said probe and said DUT.

**23.** The method of claim 22, wherein:

said transfer parameters are received from a user.

**24.** A test and measurement instrument including a processor for processing instructions stored in a memory to execute thereby a method comprising:

acquiring a plurality of samples from a device under test via a signal path including a plurality of selectable impedance loads;
adapting said selectable impedance loads to characterize the impedance of said DUT within at least one of a spectral and amplitude domain;
computing an equalization filter adapted to compensate for loading of said DUT caused by measurement of said DUT;
acquiring samples from said DUT via a signal path not including said selectable impedance loads; and
processing said acquired samples using said equalization filter to effect thereby a reduction in signal error attributable to said measurement loading of said DUT.

**25.** The instrument of claim 24, wherein said method further comprises:

receiving additional characterizing information; and
using said additional characterizing information to compute said equalization filter.

FIG.1

FIG.2

FIG.3

EP 1 569 005 A2

FIG.4

EP 1 569 005 A2

**FIG.5**

CONTAINS OWN S PARAMETERS

SCOPE

PROBE S PARAMETERS STORED HERE

PROBE PLUGS INTO FIXTURE FOR CAL PROCEDURE

USB OR OTHER COM LINK

FIXTURE

FIG.6

DUT

FIXTURE CONTAINS MULTIPLE LOADS. ALSO CONTAINS IT'S OWN S PARAMETERS. FIXTURE CONNECTS TO DUT FOR CAL PROCEDURE

EP 1 569 005 A2

FIG.7

EP 1 569 005 A2